# EUROPEAN PATENT SPECIFICATION

(11) **EP 2 057 746 B1**
(45) Date of publication and mention of the grant of the patent: **23.02.2011**
(21) Application number: 07789242.0
(22) Date of filing: 17.08.2007
(51) Int. Cl.: H04B 1/16

(54) **WIRELESS RECEIVER AND METHOD OF SAVING POWER**
DRAHTLOSER EMPFÄNGER UND VERFAHREN ZUM SPAREN VON STROM
RÉCEPTEUR SANS FIL ET PROCÉDÉ D'ÉCONOMIE D'ÉNERGIE

(30) Priority: 18.08.2006 GB 0616518
(43) Date of publication of application: 13.05.2009
(73) Proprietor: ITI Scotland Limited, Glasgow G2 2LB (GB)
(72) Inventor: PHILIPS, Desmond, Cambridge CB4 0DW (GB); DONOGHUE, Bryan, James, Cambridge CB4 0DW (GB); HAYES, Matthew, Cambridge CB4 0DW (GB)
(74) Representative: Rees, Simon John Lewis
(86) International application number: PCT/GB2007/003127
(87) International publication number: WO 2008/020216

(56) References cited:
- WO-A-00/55977
- WO-A-01/18970
- US-B1- 6 864 817

## Description

### Technical field of the invention

The invention relates to a wireless receiver and a method of saving power in a wireless receiver, and in particular to an ultra-wideband (UWB) receiver and method using a power-saving analogue-to-digital converter with switchable resolution.

### Background of the invention

Ultra-wideband is a radio technology that transmits digital data across a very wide frequency range, 3.1 to 10.6 GHz. It makes use of ultra low transmission power, typically less than -41 dBm/MHz, so that the technology can literally hide under other transmission frequencies such as existing Wi-Fi, GSM and Bluetooth. This means that ultra-wideband can co-exist with other radio frequency technologies. However, this has the limitation of limiting communication to distances of typically 5 to 20 metres.

There are two approaches to UWB: the time-domain approach, which constructs a signal from pulse waveforms with UWB properties, and a frequency-domain modulation approach using conventional FFT-based Orthogonal Frequency Division Multiplexing (OFDM) over Multiple (frequency) Bands, giving MB-OFDM. Both UWB approaches give rise to spectral components covering a very wide bandwidth in the frequency spectrum, hence the term ultra-wideband, whereby the bandwidth occupies more than 20 per cent of the centre frequency, typically at least 500MHz.

These properties of ultra-wideband, coupled with the very wide bandwidth, mean that UWB is an ideal technology for providing high-speed wireless communication in the home or office environment, whereby the communicating devices are within a range of 20m of one another.

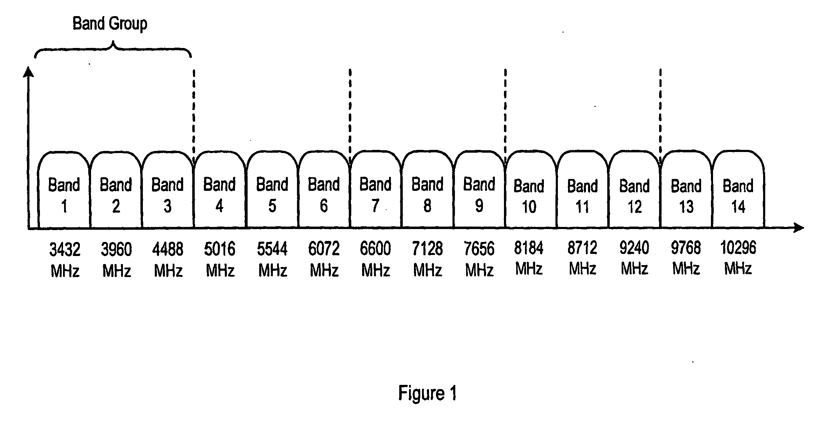

Figure 1 shows the arrangement of frequency bands in a multi-band orthogonal frequency division multiplexing (MB-OFDM) system for ultra-wideband communication. The MB-OFDM system comprises fourteen sub-bands of 528 MHz each, and uses frequency hopping every 312 ns between sub-bands as an access method. Within each sub-band OFDM and QPSK or DCM coding is employed to transmit data. It is noted that the sub-band around 5 GHz, currently 5.1-5.8 GHz, is left blank to avoid interference with existing narrowband systems, for example 802.11a WLAN systems, security agency communication systems, or the aviation industry.

The fourteen sub-bands are organized into five band groups: four having three 528 MHz sub-bands, and one having two 528 MHz sub-bands. As shown in Figure 1, the first band group comprises sub-band 1, sub-band 2 and sub-band 3. An example UWB system will employ frequency hopping between sub-bands of a band group, such that a first data symbol is transmitted in a first 312.5 ns duration time interval in a first frequency sub-band of a band group, a second data symbol is transmitted in a second 312.5 ns duration time interval in a second frequency sub-band of a band group, and a third data symbol is transmitted in a third 312.5 ns duration time interval in a third frequency sub-band of the band group. Therefore, during each time interval a data symbol is transmitted in a respective sub-band having a bandwidth of 528 MHz, for example sub-band 2 having a 528 MHz baseband signal centred at 3960 MHz

The basic timing structure of a UWB system is a superframe. A suferframe consists of 256 medium access slots (MAS), where each MAS has a defined duration, for example 256µs. Each superframe starts with a Beacon Period, which lasts one or more contiguous MASs. The start of the first MAS in the beacon period is known as the "beacon period start".

The technical properties of ultra-wideband mean that it is being deployed for applications in the field of data communications. For example, a wide variety of applications exist that focus on cable replacement In the following environments:
- communication between PCs and peripherals, i.e. external devices such as hard disc drives, CD writers, printers, scanner, etc.
- home entertainment, such as televisions and devices that connect by wireless means, wireless speakers, etc.
- communication between handheld devices and PCs, for example mobile phones and PDAs, digital cameras and MP3 players, etc.

Receivers for MB-OFDM UWB links require a very fast analogue-to-digital converter (ADC) with high resolution. A typical ADC for this link will capture a pair of (I,Q) samples at 528 MHz, with a resolution of six bits for each sample. The power consumption of the ADC increases with increasing sample rate. The power consumption of the ADC also increases exponentially with sample resolution, since the ADC will be a flash converter where power consumption is proportional to the number of comparators, and the number of comparators is proportional to 2^{resolution}. The power consumption of two 528 MHz ADCs with six bits of resolution will therefore be very high.

WO 00/55977 and WO 01/18970 disclose ADC receivers in which the resolution of an ADC converter is changed according to the quality of a received signal.

MB-OFDM UWB will be used in portable devices where low power consumption is very important. It is desirable that the UWB receiver within these devices operates continuously, so that it is able to receive frames transmitted by other devices. However, if the UWB receiver operates continuously, this will place an unacceptable load on the power supply, i.e. battery, of a portable device, because the receiver ADC will consume too much power.

The problem of the ADC consuming too much power can be mitigated using two known strategies:
1. The user might be required to switch on the receiver during periods when communication takes place, and then switch off the receiver following communication. This solution is undesirable because frames may be missed if the user does not switch on the receiver. Additionally power may be wasted if the user does not switch off the receiver.
2. The receiver can enter a "snooze" mode if no frames have been received for some time. The receiver can then wake up periodically to sense for frame activity. This solution is not ideal since the receiver may miss frames while it is "snoozing".

It is an aim of the present invention to provide an improved wireless receiver, and a method of saving power in a wireless receiver.

### Summary of the invention

According to the present invention, there is provided a receiver for receiving a wireless communication signal, the receiver being operable in a first mode when the receiver is actively receiving a transmitted signal, and a second mode when the receiver is waiting to receive a transmitted signal. The receiver comprises an analogue to digital converter for converting a received analogue signal into a digital signal; and a receiver controller, adapted to control the operating resolution of the analogue to digital converter such that, in the first mode, the analogue to digital converter operates at a first resolution, and, in the second mode, the analogue to digital converter operates at a second resolution, wherein the second resolution is lower than the first resolution.

According to another aspect of the present invention, there is provided a method of saving power in a receiver having an analogue-to-digital converter for converting a received analogue signal into a digital signal. The method comprises the steps of operating the receiver in a first mode when the receiver is actively receiving a transmitted signal; and operating the receiver in a second mode when the receiver is waiting to receiving a transmitted signal. The analogue-to-digital converter has a first resolution when operating in the first mode, and a second resolution when operating in the second mode, the second resolution being lower than the first resolution.

The invention has the advantage of enabling the average power consumption of a UWB receiver to be reduced by placing the receiver in a low-power "listening" mode when it is not actively receiving a frame. In the "listening" mode, the RF and the detection correlator are active, and the ADC is placed in a low-power, low-resolution mode. Once the detection correlator detects the presence of a preamble symbol at the start of a frame, the receiver is powered-up and the ADC placed in a high-resolution mode. At the end of the frame (or at the end of the last frame of a burst of frames), the receiver may be returned to the "listening" mode.

### Brief description of the drawings

For a better understanding of the present invention, and to show more clearly how it may be carried into effect, reference will now be made, by way of example only, to the following drawings in which:
Figure 1 shows the multi-band OFDM alliance (MBOA) approved frequency spectrum of a MB-OFDM system;
Figure 2 is a block schematic diagram of a receiver according to the present invention.
Figure 3 is a flow chart detailing the steps performed by the present invention.

### Detailed description of a preferred embodiment of the present invention

The following description of the preferred embodiment is made in relation to a UWB receiver. However, it will be appreciated that the invention is also applicable to other types of wireless receivers, including UWB receivers adapted for use in standards other than the MB-OFDM standard.

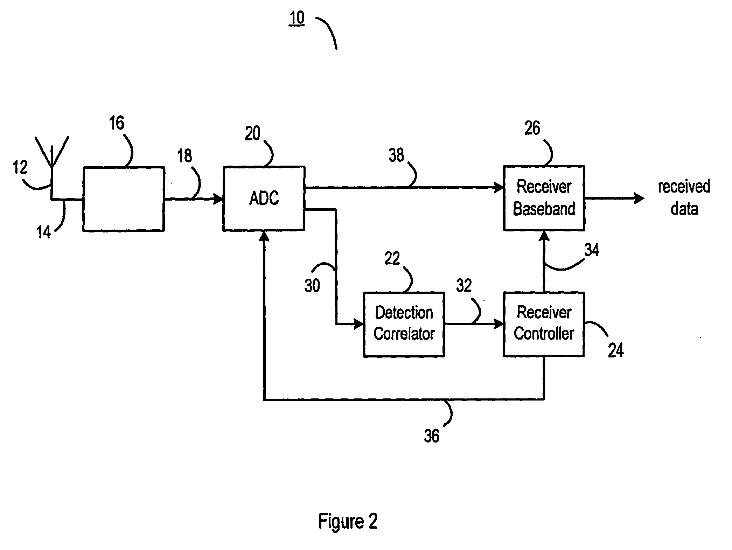

Figure 2 shows a block schematic diagram of a receiver 10 according to the present invention.

The receiver 10 comprises an antenna 12 which receives an RF signal 14. An RF section 16 amplifies the received signal 14, and outputs the amplified signal 18 to an analogue-to-digital converter 20.

The receiver 10 further comprises a detection correlator 22, a receiver controller 24, and a receiver baseband 26.

The receiver 10 has two operating modes: the "receiving" mode (or first mode) in which the receiver operates in a normal mode of operation (i.e. when receiving UWB signals from one or more other UWB devices), and a "listening" mode (or second mode) in which the receiver operates in a power saving mode according to the invention (for example when waiting to receive UWB signals from one or more other UWB devices).

While operating in the receiving mode, all sections of the receiver 10 are switched on, and the ADC 20 operates at a high resolution, for example a six bit resolution. The high-resolution output 38 is sent directly from the ADC 20 to the receiver baseband 26. It will be appreciated that, although the preferred embodiment refers to the high resolution of the ADC 20 being six bits per sample, other resolutions may also be used.

According to the invention, the receiver controller 24 is adapted to place the receiver 10 in a listening mode to conserve power. For example, the receiver 10 can be placed in the listening mode at the end of a frame, or after the last frame of a burst of frames.

In the listening mode, the receiver baseband 26 and all other non-essential sections (not shown in figure 2) are placed in a power-save mode, for example switched off, thereby reducing the power consumption of the receiver 10. The RF section 16, ADC 20, detection correlator 22 and receiver controller 24 remain switched on, although the power consumption of these blocks may be reduced from normal operation.

However, according to the invention, the ADC 20 is configured to operate at a low resolution when the receiver is in the listening mode. For example, in a preferred embodiment, the low resolution is 1-bit for each sample. The power consumption of the ADC 20 is reduced when operating in the 1-bit resolution mode because fewer comparators will be active, thereby further reducing the power consumption of the receiver 10 as a whole.

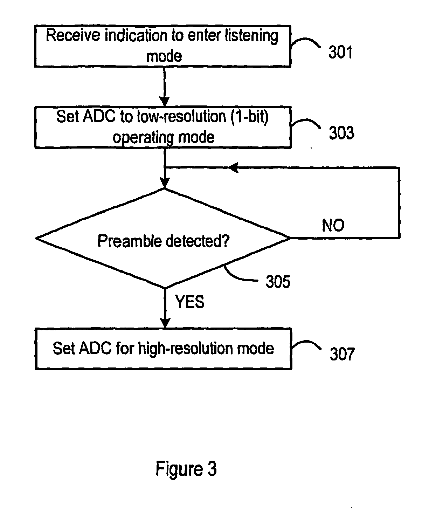

The flow diagram of Figure 3 describes the basic principles regarding how the invention controls the operation of the receiver between a normal operating mode, i.e. the receiving mode, and the low power mode, i.e. the listening mode.

Upon receiving an indication to enter the listening mode, for example an end of frame signal or after the last frame of a burst of frames, step 301, the receiver is adapted to place the ADC 20 in a low resolution mode of operation, step 303. Preferably, the low resolution mode of operation is a 1-bit mode of operation. While in the listening mode, the receiver is adapted to detect the presence of a preamble signal based on the1-bit output of the ADC 20, step 305. If no preamble is detected, the receiver remains in the listening mode, and the ADC 20 in the 1-bit mode. However, upon detection of a preamble signal, the ADC is set to the high resolution mode once more, step 307.

Thus, whilst in the listening mode, if a frame is transmitted by another device it will be amplified by the receiver RF section 16 and then passed to the ADC 20. The output of the ADC is then passed to the detection correlator 22. The detection correlator 22 is able to reliably detect the presence (or absence) of a frame preamble symbol, based on the information from a 1-bit sample of the received signal 30. When the receiver controller 24 receives a "preamble present" signal 32 from the detection correlator 22, the receiver controller 24 will immediately wake up all sections of the receiver 10 and place the ADC 20 into the high-resolution mode, so that the receiver 10 is placed in the "receiving mode", and thus able to receive the incoming frame. This is achieved by sending a "power-save" signal 34 to the receiver baseband 26, instructing the baseband 26 to exit power-save mode and power up, and sending a "resolution control" signal 36 to the ADC 20, instructing the ADC to operate at a high resolution.

At the end of the frame or at the end of the last frame in a frame burst, the receiver controller 24 sends a power-save signal 34 to the receiver baseband 26, instructing the receiver 10 to enter the power-save mode, and sends a resolution-control signal to the ADC 20, instructing the ADC 20 to operate at the lower resolution. Thereafter, the receiver 10 re-enters the listening mode.

The listening or power-save mode may be achieved, for example, by clock-gating the digital logic within the receiver baseband 26. Clock-gating temporarily disables clocks to registers within inactive digital logic. This significantly reduces the power consumption of the inactive digital logic. However, a person skilled in the art will appreciate that many other possible methods for achieving a power-save mode can be provided without departing from the scope of the present invention.

As can be seen from the above, the invention relies on the detection correlator 22 being able to reliably detect the presence of a preamble symbol in the received signal, and thereafter the receiver 10 being able to switch to receiving mode relatively quickly so that as little information is lost as possible. The invention is made possible by the fact that the preamble found in a UWB signal is relatively long. For example, the standard MB-OFDM signal includes 24 preamble symbols. However, it is possible to correctly receive a frame using fewer of these preamble symbols, say only 18 of the preamble symbols. In such a scenario, the receiver 10 can therefore afford to lose the first 6 preamble symbols of each packet. If the detection correlator 22 detects the presence of the first preamble symbol then the remainder of the receiver 10 must power-up within 5 preamble symbols (i.e. 1.5625 µs).

This enables the preamble to be detected reliably using just 1-bit resolution. For example, the 1-bit detection correlator sums how often the sign of the samples in a sliding window (equal to the length of the preamble symbol) coincides with the sign of the expected preamble signal. When this sum is compared to a pre-computed threshold, a reliable decision on the presence or absence of an MB-OFDM preamble can be made. The threshold is chosen (by modelling the statistics of the detection correlator) to achieve certain false alarm and missed frame probabilities.

The above mentioned characteristics of the preamble enable the receiver to be placed in the receiving mode without losing any data.

The ADC 20 can rapidly switch between high and low resolutions, as this merely involves powering up the necessary extra comparators, for switching to the high resolution, or powering down the unnecessary comparators, for switching to the low resolution. In addition, the receiver baseband 26 can also switch rapidly between an operational mode and a power-save mode, for example by employing clock-gating as mentioned above.

Further modifications to the receiver 10 will be apparent to the person skilled in the art. For example, the preamble-detection function of the detection correlator 22 could be replaced by an RF power detection circuit. Such a circuit would infer the presence of a transmitted signal by detecting radio-frequency power in the received signal. This is a sub-optimal solution, as the RF power detection circuit will not be able to distinguish between preamble symbols and other radio communications. However, such a system would employ the same inventive concept as the present invention, and is therefore to be considered as falling within the scope of the invention as defined in the appended claims.

In addition to changing the resolution of the ADC during the listening mode, the receiver can also be adapted to change the resolution of the ADC during the receiving mode, for example depending on the quality of the signal being received. The ADC 20 may be configured to operate at a lower resolution, such as 3-bit, 4-bit or 5-bit, when a high quality signal is being received, and to operate at a 6-bit mode of operation when a poor quality signal is being received.

It is noted that the invention may also be used with non-wireless systems where a power saving mode by reducing the accuracy of the ADC is advantageous.

It should be noted that the above-mentioned embodiments illustrate rather than limit the invention, and that those skilled in the art will be able to design many alternative embodiments without departing from the scope of the appended claims. The word "comprising" does not exclude the presence of elements or steps other than those listed in a claim, "a" or "an" does not exclude a plurality, and a single processor or other unit may fulfil the functions of several units recited in the claims. Any reference signs in the claims shall not be construed so as to limit their scope.

## Claims

1. A receiver (10) for receiving a wireless communication signal, the receiver (10) being operable in a first mode when the receiver (10) is actively receiving a transmitted signal, and a second mode when the receiver (10) is waiting to receive a transmitted signal, the receiver (10) comprising:
an analogue to digital converter (20) for converting a received analogue signal into a digital signal; and
a receiver controller (24), adapted to control the operating resolution of the analogue to digital converter (20) such that, in the first mode, the analogue to digital converter (20) operates at a first resolution, and, in the second mode, the analogue to digital converter (20) operates at a second resolution, wherein the second resolution is lower than the first resolution.

2. A receiver (10) as claimed in claim 1, wherein the second resolution of the analogue to digital converter (20) is a 1-bit resolution.

3. A receiver (10) as claimed in claim 1 or 2, further comprising:
a detection correlator (22) for receiving an output from the analogue-to-digital converter (20);
wherein the detection correlator (22) is adapted to detect the presence of a preamble symbol in the digitized signal based on the second resolution of the analogue to digital converter (20) when the receiver (10) is operating in the second mode.

4. A receiver (10) as claimed in claim 3, wherein the detection correlator (22) is adapted to detect the presence of a preamble symbol by:
summing how often the sign of samples in a sliding window coincide with the sign of the expected preamble symbol, and
comparing the sum to a predetermined threshold.

5. A receiver (10) as claimed in claim 4, wherein the detection correlator (22) is further adapted to send a first control signal to the receiver controller (24) indicating that a preamble symbol is present, thereby instructing the analogue-to-digital converter (20) to operate at the first resolution.

6. A receiver (10) as claimed in claim 1 or 2, further comprising:
an RF power detection circuit;
wherein the RF power detection circuit is adapted to detect the presence of a preamble symbol based on the power of the analogue signal.

7. A receiver (10) as claimed in claim 6, wherein the RF power detection circuit is further adapted to send a first control signal to the receiver controller (24) indicating that a preamble symbol is present, thereby instructing the analogue-to-digital converter (20) to operate at the first resolution.

8. A receiver (10) as claimed in any of the preceding claims, wherein the first resolution is six bits per sample.

9. A receiver (10) as claimed in any one of the preceding claims, wherein the receiver controller (24) is further adapted to change the first resolution of the analogue-to-digital converter (20) while the receiver is operating in the first mode.

10. A receiver (10) as claimed in any one of the preceding claims, further comprising a receiver baseband section (26) wherein, when the receiver (10) is operating in the second mode, the receiver baseband section (26) is placed in a power-saving mode.

11. A method of saving power in a wireless receiver (10) having an analogue-to-digital converter (20) for converting a received analogue signal into a digital signal, the method comprising the steps of:
operating the receiver (10) in a first mode when the receiver (10) is actively receiving a transmitted signal; and
operating the receiver (10) in a second mode when the receiver (10) is waiting to receiving a transmitted signal;
wherein the analogue-to-digital converter (20) has a first resolution when operating in the first mode, and a second resolution when operating in the second mode, the second resolution being lower than the first resolution.

12. A method as claimed in claim 11, wherein the second resolution of the analogue to digital converter (20) is set to a 1-bit resolution when operating in the second mode.

13. A method as claimed in claim 11 or 12, further comprising the step of providing a detection correlator (22) for receiving an output from the analogue-to-digital converter (20), the detection correlator (22) detecting the presence of a preamble symbol in the digitized signal based on the second resolution of the analogue to digital converter (20) when the receiver is operating in the second mode.

14. A method as defined in claim 13, wherein the step of detecting the presence of a preamble symbol comprises the steps of:
summing how often the sign of samples in a sliding window coincide with the sign of the expected preamble symbol, and
comparing the sum to a predetermined threshold.

15. A method as claimed in claim 14, further comprising the step of instructing the analogue-to-digital converter (20) to operate at the first resolution in response to the detection correlator (22) detecting the presence of a preamble symbol being present.

16. A method as claimed in claim 11 or 12, further comprising the step of providing an RF power detection circuit for detecting the presence of a preamble symbol based on the power of the received analogue signal.

17. A method as claimed in claim 16, further comprising the step of instructing the analogue-to-digital converter (20) to operate at the first resolution in response to the RF power detection circuit detecting the presence of a preamble symbol.

18. A method as claimed in any one of claims 11 to 17, wherein the step of operating the analogue-to-digital converter (20) at the first resolution comprises the step of using a resolution of six bits per sample.

19. A method as claimed in any one of claims 11 to 18, further comprising the step of changing the first resolution of the analogue-to-digital converter (20) while the receiver (10) is operating in the first mode.

20. A method as claimed in any one of claims 11 to 19, further comprising the step of providing a receiver baseband section (26), and, when the receiver is operating in the second mode, putting the receiver baseband section (26) into a power-saving mode.

21. A method as claimed in claims 20, wherein the receiver power of the baseband section (26) may be progressively reduced to optimise power consumption depending on the received signal quality of the received signal.

## Patentansprüche

1. Empfänger (10) für den Empfang eines drahtlosen Kommunikationssignals, wobei der Empfänger (10) in einem ersten Arbeitsmodus bedienbar ist, wenn der Empfänger (10) aktiv ein übertragenes Signal empfängt, und in einem zweiten Arbeitsmodus, wenn der Empfänger (10) darauf wartet, ein übertragenes Signal zu empfangen, wobei der Empfänger (10) umfasst
einen Analog-Digital-Umsetzer (20) zum Umsetzen eines empfangenen Analogsignals in ein Digitalsignal; und
eine Empfängersteuerung (24) ausgelegt für die Steuerung der Betriebsauflösung des Analog-Digital-Umsetzers (20), so dass, im ersten Arbeitsmodus, der Analog-Digital-Umsetzer (20) mit einer ersten Auflösung arbeitet und, im zweiten Arbeitsmodus, der Analog-Digital-Umsetzer (20) mit einer zweiten Auflösung arbeitet, wobei die zweite Auflösung niedriger als die erste Auflösung ist.

2. Empfänger (10) gemäß Anspruch 1, worin die zweite Auflösung des Analog-Digital-Umsetzers (20) eine 1-Bit-Auflösung ist.

3. Empfänger (10) gemäß Anspruch 1 oder 2, zudem umfassend
einen Erkennungskorrelator (22) zum Empfang einer Ausgabe vom Analog-Digital-Umsetzer (20);
worin der Erkennungskorrelator (22) ausgelegt ist zum Erkennen des Vorliegens eines Vorsatz-Symbols im digitalisierten Signal auf Basis der zweiten Auflösung des Analog-Digital-Umsetzers (20), wenn der Empfänger (10) im zweiten Arbeitsmodus arbeitet.

4. Empfänger (10) gemäß Anspruch 3, worin der Erkennungskorrelator (22) ausgelegt ist zum Erkennen des Vorliegens eines Vorsatz-Symbols durch
Summieren, wie oft das Zeichen von Proben in einem Gleitfenster mit dem Zeichen des erwarteten Vorsatz-Symbols übereinstimmt, und
Vergleichen der Summe mit einem vorbestimmten Grenzwert.

5. Empfänger (10) gemäß Anspruch 4, worin der Erkennungskorrelator (22) zudem ausgelegt ist, ein erstes Steuersignal an die Empfängersteuerung (24) zu senden, welches angibt, dass ein Vorsatz-Symbol vorliegt, wodurch der Analog-Digital-Umsetzer (20) angewiesen wird, mit der ersten Auflösung zu arbeiten.

6. Empfänger (10) gemäß Anspruch 1 oder 2, zudem umfassend
eine RF-Stromerkennungsschaltung;
worin die RF-Stromerkennungsschaltung ausgelegt ist, das Vorliegen eines Vorsatz-Symbols auf Basis der Stärke des analogen Signals zu erkennen.

7. Empfänger (10) gemäß Anspruch 6, worin die RF-Stromerkennungsschaltung zudem ausgelegt ist, ein erstes Steuerungssignal an die Empfängersteuerung (24) zu senden, welches angibt, dass ein Vorsatz-Symbol vorliegt, wodurch der Analog-Digital-Umsetzer (20) angewiesen wird, mit der ersten Auflösung zu arbeiten.

8. Empfänger (10) gemäß irgendeinem der vorherigen Ansprüche, worin die erste Auflösung sechs Bit pro Probe ist.

9. Empfänger (10) gemäß irgendeinem der vorherigen Ansprüche, worin die Empfängersteuerung (24) zudem ausgelegt ist, die erste Auflösung des Analog-Digital-Umsetzers (20) zu verändern, während der Empfänger im ersten Arbeitsmodus arbeitet.

10. Empfänger (10) gemäß irgendeinem der vorherigen Ansprüche, worin zudem umfassend eine Empfänger-Basisbandsektion (26), worin, arbeitet der Empfänger (10) im zweiten Arbeitsmodus, die Empfänger-Basisbandsektion (26) in einen Stromsparmodus gesetzt wird.

11. Verfahren zum Stromsparen in einem drahtlosen Empfänger (10) mit einem Analog-Digital-Umsetzer (20) zum Umsetzen eines empfangenen Analogsignals in ein Digitalsignal, wobei das Verfahren die Schritte umfasst
Betreiben des Empfängers (10) in einem ersten Arbeitsmodus, wenn der Empfänger (10) aktiv ein übertragenes Signal empfängt; und
Betreiben des Empfängers (10) in einem zweiten Arbeitsmodus, wenn der Empfänger (10) darauf wartet, ein übertragenes Signal zu empfangen;
worin der Analog-Digital-Umsetzer (20) eine erste Auflösung hat bei Betrieb im ersten Arbeitsmodus und eine zweite Auflösung bei Betrieb im zweiten Arbeitsmodus, wobei die zweite Auflösung niedriger als die erste Auflösung ist.

12. Verfahren gemäß Anspruch 11, worin die zweite Auflösung des Analog-Digital-Umsetzers (20) bei Betrieb im zweiten Arbeitsmodus auf eine 1-Bit-Auflösung eingestellt wird.

13. Verfahren gemäß Anspruch 11 oder 12, zudem umfassend das Bereitstellen eines Erkennungskorrelators (22) zum Empfang einer Ausgabe vom Analog-Digital-Umsetzer (20), wobei der Erkennungskorrelator (22) das Vorliegen eines Vorsatz-Symbols im digitalisierten Signal erkennt, auf Basis der zweiten Auflösung des Analog-Digital-Umsetzers (20), wenn der Empfänger im zweiten Arbeitsmodus arbeitet.

14. Verfahren gemäß Anspruch 13, worin das Erkennen des Vorliegens eines Vorsatz-Symbols umfasst die Schritte
Summieren, wie oft das Zeichen von Proben in einem Gleitfenster mit dem Zeichen des erwarteten Vorsatz-Symbols übereinstimmt, und
Vergleichen der Summe mit einem vorbestimmten Grenzwert.

15. Verfahren gemäß Anspruch 14, zudem umfassend das Anweisen des Analog-Digital-Umsetzers (20), mit der ersten Auflösung zu arbeiten als Reaktion darauf, dass der Erkennungskorrelator (22) das Vorliegen eines Vorsatz-Symbols erkennt.

16. Verfahren gemäß Anspruch 11 oder 12, zudem umfassend das Bereitstellen einer RF-Stromerkennungsschaltung zum Erkennen des Vorliegens eines Vorsatz-Symbols auf Basis der Stärke des empfangenen analogen Signals.

17. Verfahren gemäß Anspruch 16, zudem umfassend das Anweisen des Analog-Digital-Umsetzers (20), mit der ersten Auflösung zu arbeiten als Reaktion darauf, dass die RF-Stromerkennungsschaltung das Vorliegen eines Vorsatz-Symbols erkennt.

18. Verfahren gemäß irgendeinem der Ansprüche 11 bis 17, worin das Betreiben des Analog-Digital-Umsetzers (20) mit der ersten Auflösung das Verwenden einer Auflösung von sechs Bit pro Probe umfasst.

19. Verfahren gemäß irgendeinem der Ansprüche 11 bis 18, zudem umfassend das Ändern der ersten Auflösung des Analog-Digital-Umsetzers (20), während der Empfänger (10) im ersten Arbeitsmodus arbeitet.

20. Verfahren gemäß irgendeinem der Ansprüche 11 bis 19, zudem umfassend das Bereitstellen einer Empfänger-Basisbandsektion (26) und, arbeitet der Empfänger (10) im zweiten Arbeitsmodus, das Einstellen der Empfänger-Basisbandsektion (26) in einen Stromsparmodus.

21. Verfahren gemäß Anspruch 20, worin der Empfängerstrom der Basisbandsektion (26) stufenweise verringert werden kann, um den Stromverbrauch zu optimieren, abhängig von der Empfagssignalqualität des empfangenen Signals.

## Revendications

1. Récepteur (10) pour recevoir un signal de communication sans fil, le récepteur (10) pouvant fonctionner dans un premier mode lorsque le récepteur (10) reçoit activement un signal transmis, et un second mode lorsque le récepteur (10) attend de recevoir un signal transmis, le récepteur (10) comprenant :
un convertisseur analogique-numérique (20) pour convertir un signal analogique reçu en un signal numérique ; et
un contrôleur de récepteur (24), adapté pour contrôler la résolution de fonctionnement du convertisseur analogique-numérique (20) de sorte que, dans le premier mode, le convertisseur analogique-numérique (20) fonctionne à une première résolution, et, dans le second mode, le convertisseur analogique-numérique (20) fonctionne à une seconde résolution, où la seconde résolution est inférieure à la première résolution.

2. Récepteur (10) selon la revendication 1, dans lequel la seconde résolution du convertisseur analogique-numérique (20) est une résolution à 1 bit.

3. Récepteur (10) selon la revendication 1 ou 2, comprenant en outre :
un corrélateur de détection (22) pour recevoir une sortie du convertisseur analogique-numérique (20) ;
dans lequel le corrélateur de détection (22) est adapté pour détecter la présence d'un symbole de préambule dans le signal numérisé sur la base de la seconde résolution du convertisseur analogique-numérique (20) lorsque le récepteur (10) fonctionne dans le second mode.

4. Récepteur (10) selon la revendication 3, dans lequel le corrélateur de détection (22) est adapté pour détecter la présence d'un symbole de préambule en :
sommant la fréquence à laquelle le signe d'échantillons dans une fenêtre glissante coïncide avec le signe du symbole de préambule escompté, et
comparant la somme à un seuil prédéterminé.

5. Récepteur (10) selon la revendication 4, dans lequel le corrélateur de détection (22) est en outre adapté pour envoyer un premier signal de contrôle au contrôleur de récepteur (24) indiquant qu'un symbole de préambule est présent, donnant ainsi pour instruction au convertisseur analogique-numérique (20) de fonctionner à la première résolution.

6. Récepteur (10) selon la revendication 1 ou 2, comprenant en outre :
un circuit de détection de puissance RF ;
dans lequel le circuit de détection de puissance RF est adapté pour détecter la présence d'un symbole de préambule sur la base de la puissance du signal analogique.

7. Récepteur (10) selon la revendication 6, dans lequel le circuit de détection de puissance RF est en outre adapté pour envoyer un premier signal de contrôle au contrôleur de récepteur (24) indiquant qu'un symbole de préambule est présent, donnant ainsi pour instruction au convertisseur analogique-numérique (20) de fonctionner à la première résolution.

8. Récepteur (10) selon l'une quelconque des revendications précédentes, dans lequel la première résolution est de six bits par échantillon.

9. Récepteur (10) selon l'une quelconque des revendications précédentes, dans lequel le contrôleur de récepteur (24) est en outre adapté pour changer la première résolution du convertisseur analogique-numérique (20) pendant que le récepteur fonctionne dans le premier mode.

10. Récepteur (10) selon l'une quelconque des revendications précédentes, comprenant en outre une section de bande de base de récepteur (26) où, lorsque le récepteur (10) fonctionne dans le second mode, la section de bande de base de récepteur (26) est placée dans un mode d'économie d'énergie.

11. Procédé d'économie d'énergie dans un récepteur sans fil (10) ayant un convertisseur analogique-numérique (20) pour convertir un signal analogique reçu en un signal numérique, le procédé comprenant les étapes consistant à :
faire fonctionner le récepteur (10) dans un premier mode lorsque le récepteur (10) reçoit activement un signal transmis ; et
faire fonctionner le récepteur (10) dans un second mode lorsque le récepteur (10) attend de recevoir un signal transmis ;
dans lequel le convertisseur analogique-numérique (20) a une première résolution lorsqu'il fonctionne dans le premier mode, et une seconde résolution lorsqu'il fonctionne dans le second mode, la seconde résolution étant inférieure à la première résolution.

12. Procédé selon la revendication 11, dans lequel la seconde résolution du convertisseur analogique-numérique (20) est établie à une résolution à 1 bit lorsqu'il fonctionne dans le second mode.

13. Procédé selon la revendication 11 ou 12, comprenant en outre l'étape consistant à fournir un corrélateur de détection (22) pour recevoir une sortie du convertisseur analogique-numérique (20), le corrélateur de détection (22) détectant la présence d'un symbole de préambule dans le signal numérisé sur la base de la seconde résolution du convertisseur analogique-numérique (20) lorsque le récepteur fonctionne dans le second mode.

14. Procédé selon la revendication 13, dans lequel l'étape de détection de la présence d'un symbole de préambule comprend les étapes consistant à :
sommer la fréquence à laquelle le signe d'échantillons dans une fenêtre glissante coïncide avec le signe du symbole de préambule escompté, et
comparer la somme à un seuil prédéterminé.

15. Procédé selon la revendication 14, comprenant en outre l'étape consistant à donner pour instruction au convertisseur analogique-numérique (20) de fonctionner à la première résolution en réponse au corrélateur de détection (22) détectant la présence d'un symbole de préambule qui est présent.

16. Procédé selon la revendication 11 ou 12, comprenant en outre l'étape consistant à fournir un circuit de détection de puissance RF pour détecter la présence d'un symbole de préambule sur la base de la puissance du signal analogique reçu.

17. Procédé selon la revendication 16, comprenant en outre l'étape consistant à donner pour instruction au convertisseur analogique-numérique (20) de fonctionner à la première résolution en réponse au circuit de détection de puissance RF détectant la présence d'un symbole de préambule.

18. Procédé selon l'une quelconque des revendications 11 à 17, dans lequel l'étape consistant à faire fonctionner le convertisseur analogique-numérique (20) à la première résolution comprend l'étape consistant à utiliser une résolution de six bits par échantillon.

19. Procédé selon l'une quelconque des revendications 11 à 18, comprenant en outre l'étape consistant à changer la première résolution du convertisseur analogique-numérique (20) pendant que le récepteur (10) fonctionne dans le premier mode.

20. Procédé selon l'une quelconque des revendications 11 à 19, comprenant en outre l'étape consistant à fournir une section de bande de base de récepteur (26), et, lorsque le récepteur fonctionne dans le second mode, mettre la section de bande de base de récepteur (26) en mode d'économie d'énergie.

21. Procédé selon la revendication 20, dans lequel la puissance de récepteur de la section de bande de base (26) peut être réduite progressivement afin d'optimiser la consommation d'énergie en fonction de la qualité de signal reçue du signal reçu.
